# EUROPEAN PATENT APPLICATION

(11) **EP 4 721 597 A1**
(43) Date of publication of application: **08.04.2026**
(21) Application number: 24814027.9
(22) Date of filing: 23.04.2024
(51) Int. Cl.: A24F 40/46, A24F 40/40, A24F 40/70

(54) **HEATING THIN FILM, ATOMIZATION CORE, AND ATOMIZATION DEVICE**

(30) Priority: 31.05.2023 CN 202310636422
(71) Applicant: Smoore International Holdings Limited, Grand Cayman, KY1-1111 (KY)
(72) Inventor: ZHENG, Liqing, Shenzhen, Guangdong 518102 (CN); CHEN, Shuting, Shenzhen, Guangdong 518102 (CN); WANG, Wei, Shenzhen, Guangdong 518102 (CN); FENG, Jianming, Shenzhen, Guangdong 518102 (CN); TANG, Ming, Shenzhen, Guangdong 518102 (CN); ZHU, Mingda, Shenzhen, Guangdong 518102 (CN)
(74) Representative: Winter, Brandl - Partnerschaft mbB
(86) International application number: PCT/CN2024/089325
(87) International publication number: WO 2024/244821

(57) **Abstract**

This application relates to the technical field of e-cigarettes, and in particular, to a heating thin film, an e-cigarette atomization component, and an e-cigarette. This application provides a heating thin film, the heating thin film being an iron-based alloy thin film, and the iron-based alloy thin film having an equiaxed crystal structure. The iron-based alloy heating thin film in this application has an equiaxed crystal structure. Grains grow isotropically and are not obviously oriented. This overcomes the disadvantage of the short service life of the heating thin film of a prismatic crystal structure, so that the performance requirements on the resistance to dry and wet burning of the heating film in a use process of the atomization core can be met, and compared with a platinum heating thin film, the costs are significantly reduced.

## Description

### CROSS-REFERENCE TO RELATED APPLICATIONS

This application claims priority to Chinese Patent Application No. 202310636422.7, filed with the China National Intellectual Property Administration on May 31, 2023 and entitled "HEATING THIN FILM, ATOMIZATION CORE, AND ATOMIZATION APPARATUS", which is incorporated herein by reference in its entirety.

### TECHNICAL FIELD

This application relates to a heating thin film, an e-cigarette atomization component, and an e-cigarette, and relates to the technical field of e-cigarettes.

### BACKGROUND

A conventional thick film is usually replaced with a thin film-type heating film in a new electronic atomization component. The thin film-type heating film has the advantages of a good material consistency and a thin film layer thickness, and in addition, the film-type heating thin film is not filled in micro pores on the heating surface of a cellular substrate, so that the transmission speed of an e-liquid is not affected, and a relatively high atomization efficiency can be achieved. A common metal type resistive heating thin film is mainly of a low-resistivity metal material such as Ag, Cu, and Al.

During use of the electronic atomization component, the electronic atomization component has the following problems: On one hand, if insufficient liquid supply exists in a heat atomization process, the dry-burning temperature of the heating film may even reach a temperature greater than 1000°C, which easily causes a failure of the heating film due to dry-burning. On the other hand, the atomization is implemented by the heating film by heating using electricity (a potential difference is usually approximately 3-4 V). In addition, due to the fact that there are many e-liquid types, and the composition of the e-liquid also includes some corrosion media, in the atomization process, the metal heating film is prone to be subject to an electro-chemical corrosion phenomenon, thereby causing a corrosion failure of the heating film. Therefore, the electronic atomization component has a very severe requirement for a metal heating thin film, and needs to meet both performance requirements of dry burning and wet burning. It is difficult for a common metal heating thin film to meet the requirements.

Currently, a heating film system completely meeting the requirements is mainly made of the precious metal platinum. However, the costs of the material are extremely high, and have great cost resistance to subsequent production and promotion of a heating body. Therefore, it is urgent to develop a low-cost heating thin film based on a base metal material, and meet the requirements on the resistance to dry and wet burning of a heating film of an electronic atomization component.

### SUMMARY

A technical problem to be solved by this application is to provide a heating thin film based on an iron-based alloy, so as to reduce the production cost of the heating thin film, and the thin film can meet the performance requirements on the resistance to dry and wet burning of a heating film of an electronic atomization component. This application is implemented by using the following technical solution:
A heating thin film, the heating thin film being an iron-based alloy thin film, and the iron-based alloy thin film having an equiaxed crystal structure.

Optionally, the heating thin film has a thickness of 0.5-3 µm.

Optionally, the iron-based alloy thin film is a stainless steel thin film.

Optionally, the iron-based alloy thin film includes the following components based on mass percentage:
Fe: 61-72%, Cr: 16-20%, Ni: 10-15%, and Mo: 2-4%.

Optionally, the iron-based alloy thin film includes the following components based on mass percentage:
Fe: 67-72%, Cr: 16-18%, Ni: 10-12%, and Mo: 2-3%.

Optionally, the iron-based alloy thin film includes the following components based on mass percentage:
Fe: 61-67%, Cr: 18-20%, Ni: 12-15%, and Mo: 3-4%.

Optionally, the content of other elements in the iron-based alloy thin film is lower than 1% based on mass percentage of the iron-based alloy thin film.

Optionally, the iron-based alloy thin film has an austenite crystal phase having a face-centered cubic structure; and
the iron-based alloy thin film is measured by CuKα radiation and θ-2θ scanning, where in an x-ray diffraction pattern exhibited by the iron-based alloy thin film, the ratio of an x-ray diffraction peak intensity of a crystal (111) plane to an x-ray diffraction peak intensity of a (200) plane is (1-3.5) : 1.

Optionally, the iron-based alloy thin film has no crystal boundaries along the thickness direction.

This application further provides a method for forming the heating thin film, including the following steps:
step 1): forming an iron-based alloy thin film by physical vapor deposition;
step 2): performing heat treatment on the iron-based alloy thin film in step 1), for the iron-based alloy thin film to form an equiaxed crystal structure, thereby obtaining the heating thin film.

Optionally, in step 1), the iron-based alloy thin film is formed by co-sputtering an elemental metal target by physical vapor deposition or sputtering an alloy target by physical vapor deposition.

Optionally, a method for the heat treatment in step 2) is: keeping the temperature in a range of 600-800°C for 30 min at a vacuum level lower than 5*10⁻² Pa, and performing cooling after the temperature keeping is ended.

Optionally, cooling with the furnace is carried out after the temperature keeping in step (2) is ended.

Optionally, in step 2), temperature keeping is performed for 30-120 min at a vacuum level of 3*10⁻⁴ Pa to 5*10⁻² Pa at the temperature of 700-800°C.

This application further provides an e-cigarette atomization core, the e-cigarette atomization core including the heating thin film.

Optionally, the atomization core includes a heating substrate, the heating thin film is provided on the heating substrate, and a protective film is provided on the heating thin film.

This application further provides an atomization apparatus, the atomization apparatus including the heating thin film and/or the atomization core.

Compared with the prior art, this application has the following beneficial effects:
This application provides a heating thin film, where the heating thin film is an iron-based alloy thin film, and the iron-based alloy thin film is of an equiaxed crystal structure. Iron-based alloys such as stainless steel have a particular corrosion resistance and oxidation resistance, and can be used for making a heating material. However, when a thin film is formed, the iron-based alloys such as stainless steel block materials usually have a prismatic crystal structure, growing along a particular crystal direction, and having a large defect content, and when being used as a heating thin film for dry and wet burning tests, the iron-based alloys or stainless steel block materials are apt to oxidation or corrosion along prismatic crystal boundaries, resulting in an excessively large increase in the resistance and a shortened service life. However, the heating thin film in this application has an equiaxed crystal structure. Grains grow isotropically and are not obviously oriented. This overcomes the disadvantage of the short service life of the heating thin film of a prismatic crystal structure, so that the performance requirements on the resistance to dry and wet burning of the heating film in a use process of the atomization core can be met, and compared with a platinum heating thin film, the costs are significantly reduced.

### BRIEF DESCRIPTION OF THE DRAWINGS

FIG. 1 is a cross-sectional topographic diagram of a heating thin film of Example 1;
FIG. 2 is a cross-sectional topographic diagram of a heating thin film of Example 2;
FIG. 3 is a cross-sectional topographic diagram of a heating thin film of Control Example 1;
FIG. 4 is a cross-sectional topographic diagram of a heating thin film of Control Example 2; and
FIG. 5 is an x-ray diffraction pattern of a heating film of each example and a control example.

### DETAILED DESCRIPTION

Iron-based alloys such as stainless steel have a particular corrosion resistance and oxidation resistance, and can be used for making a heating material. However, when a thin film is formed, a stainless steel block material usually has a prismatic crystal structure, growing along a particular crystal direction, and having a large defect content, and when being used as a heating thin film for dry and wet burning tests, the iron-based alloys or stainless steel block materials are apt to oxidation or corrosion along prismatic crystal boundaries, resulting in an excessively large increase in the resistance and a shortened service life. This application provides a heating thin film, the heating thin film being an iron-based alloy thin film, and the iron-based alloy thin film having an equiaxed crystal structure. In a thin film of such the equiaxed crystal structure, grains grow isotropically and are not obviously oriented. This overcomes the disadvantage of the short service life of the heating thin film of a prismatic crystal structure. In addition, compared with a platinum heating thin film, the costs are significantly reduced. In a specific implementation, the iron-based alloy thin film is of an equiaxed crystal structure.

In an optional implementation, the heating thin film has a thickness of 0.5-3 µm. For example, the thin film has a thickness of 0.5 µm, 1 µm, 1.5 µm, 2 µm, 2.5 µm, 3 µm, 3.5 µm, 4 µm, 4.5 µm, or 5 µm.

In an optional implementation, the iron-based alloy thin film is a stainless steel thin film. In an optional implementation, the iron-based alloy thin film includes the following components based on mass percentage: Fe: 61-72%, Cr: 16-20%, Ni: 10-15%, and Mo: 2-4%. Optionally, the iron-based alloy thin film includes based on mass percentage: Fe: 67-72%, Cr: 16-18%, Ni: 10-12%, and Mo: 2-3%. Optionally, the iron-based alloy thin film includes based on mass percentage: Fe: 61-67%, Cr: 18-20%, Ni: 12-15%, and Mo: 3-4%.

In an optional implementation, the iron-based alloy thin film has an austenite crystal phase having a face-centered cubic structure; and the iron-based alloy thin film is measured by CuKα radiation and θ-2θ scanning, where in an x-ray diffraction pattern exhibited by the iron-based alloy thin film, the ratio of an x-ray diffraction peak intensity of a crystal (111) plane to an x-ray diffraction peak intensity of a (200) plane is (1-3.5) : 1. In an optional implementation, the iron-based alloy thin film has no crystal boundaries along the thickness direction. The high-temperature oxidization resistance and the electrochemical corrosion resistance are strong.

This application further provides a method for forming the heating thin film, including the following steps:
step 1): forming an iron-based alloy thin film by physical vapor deposition;
step 2): performing heat treatment on the iron-based alloy thin film in step 1), for the iron-based alloy thin film to form an equiaxed crystal structure, thereby obtaining the heating thin film. According to the forming method, a thin film having a thickness of 0.5-3 µm is formed by using a method of physical vapor deposition, and then heat treatment is performed, to obtain a heating thin film. The formed heating thin film has a uniform and dense thickness, has a high-temperature oxidization resistance and an electrochemical corrosion resistance, and has low manufacturing costs.

In an optional implementation, in step 1), the iron-based alloy thin film is formed by co-sputtering an elemental metal target by physical vapor deposition or sputtering an alloy target by physical vapor deposition.

In an optional implementation, a method for the heat treatment in step 2) is: keeping the temperature in a range of 700-800°C for 30 min at a vacuum level lower than 5*10⁻³ Pa, and performing cooling after the temperature keeping is ended. In an optional implementation, cooling with the furnace is carried out after the temperature keeping is ended. In an optional implementation, the heat treatment includes keeping the temperature in a range of 700-800°C for 30-120 min at a vacuum level in a range of 3*10⁻⁴ Pa to 5*10⁻² Pa, and performing cooling after the temperature keeping is ended.

This application further provides an e-cigarette atomization core. The e-cigarette atomization component includes the heating thin film. In an optional implementation, the atomization core includes a heating substrate, the heating thin film is provided on the heating substrate, and a protective film is provided on the heating thin film.

This application further provides an atomization apparatus. The atomization apparatus includes at least one of the heating thin film and the e-cigarette atomization core.

The atomization core and atomization apparatus having the heating thin film can resist high-temperature oxidation to some extent in a dry burning test of the heating film, to ensure that an increase in the resistance is < 20% in an 8.5 W dry burning test; and in a wet burning test of the heating film, the electrochemical corrosion resistance performance of the thin film can also be improved, to ensure that the resistance value is maintained to be stable in a long-time powered-on environment and in an e-liquid environment.

The following examples are provided only for the purpose of describing this application in more detail. Therefore, according to the objective of this application, the examples apparent to a person skilled in the art should not be construed as limiting the scope of this application. The materials involved in the examples are all commercial products.

A method for testing a resistance change in the examples and the control examples is: a method for testing a resistance change by dry burning: first testing an initial resistance R0 of the heating film, powering on the heating film at a constant power of 7.5 W for 3s and then stopping for 8s, then performing dry burning in air for 10 periods, and then testing a resistance R10 after the heating film undergone dry burning for 10 periods, so that the resistance change rate ΔR=(R10-R0)/R0 before and after dry burning can be calculated, the resistance change rate being required as ΔR < 20%.

A method for testing a resistance change by wet burning: first feeding an e-liquid into a heating body, testing an initial resistance value R0 after feeding is finished, powering on by using a selected 7.5 W constant power battery for 3s and then stopping for 15s, testing the resistance Rx of the cigarette cartridge heating film after vaping by 150 periods, and calculating a resistance change rate ΔR=(Rx-R0)/R0 before and after wet burning, the resistance change rate being required as ΔR < 20%.

In the examples and the control examples, the cross-sectional topography of the heating thin film is obtained by: splitting a sample to obtain a natural cross-section, sputtering the electrically-conductive layer Pt for 20s, and observing by using an FEI Apreo C Lovac field-emitting scanning electron microscope.

In the examples and the control examples, an x-ray diffraction pattern is obtained by: performing object phase analysis by using a Rigaku Miniflex X-ray Diffractometer (XRD), a scanning range being 30° to 90°.

The strawberry-watermelon-ice-fruit e-liquid in the examples is: the strawberry-watermelon e-liquid (40 mg) produced by Shenzhen Yupeng Technology Co., Ltd.

### Example 1

Production of a heating thin film:
Step 1): Form, on a heating substrate, an iron-based alloy thin film by using a method of performing direct current (DC) sputtering on an alloy target by using a magnetron spraying device, where the iron-based alloy thin film includes, based on mass percentage: Fe: 70%, Cr: 16.5%, Ni: 10.5%, and Mo: 2.5%, the alloy includes unavoidable impurity content such as C, Si, and P, and a total impurity mass percentage is less than 1%. The heating substrate has an array hole structure and has a void volume of 20%.
Step 2): Perform heat treatment on the formed iron-based alloy thin film, to keep the iron-based alloy thin film at 800°C for 30 min at a vacuum level of 3*10⁻³ Pa, and subsequently, perform cooling with the furnace, to obtain the heating substrate covered by the heating thin film.

A layer of 100 nm of Al₂O₃ protective film is deposited on the surface of the heating thin film, and then the protective film is assembled into a heating component, the effective heating area of the heating thin film being 3.5 mm² (the void ratio is not considered for the value). Further assembly is performed to form the e-cigarette. Dry burning and wet burning tests are performed on the assembled e-cigarette, and test results are as follows:
The dry burning capability of the heating thin film: a change in the resistance at 8.5 W after dry burning by 10 puffs is 18% (powering on at a constant power of 8.5 W for 3s, and stopping for dry burning in air for 8s); the wet burning capability of the heating thin film: a change in the resistance of the strawberry-watermelon-ice-fruit e-liquid at 7.5 W after wet burning by 800 puffs is 14.5% (vaping at 7.5 W for 3s and stopping for 15s, the capacity being 55 mL).

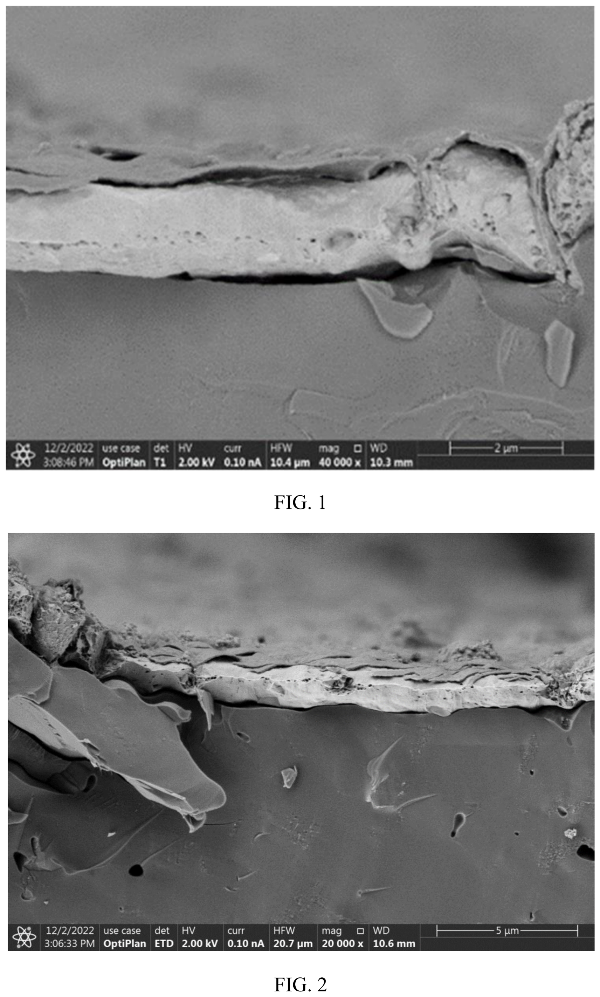

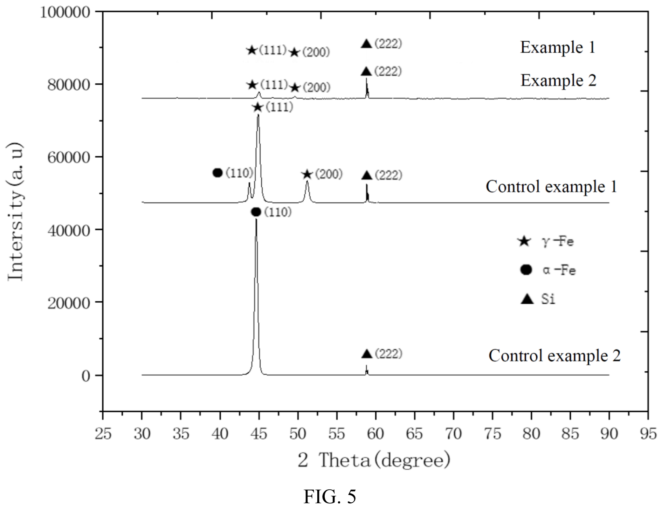

The cross-sectional topography of the heating thin film is shown in FIG. 1: the thickness of the thin film is 1600 nm. The thin film is dense, is a block-like equiaxed crystal, and has no obvious crystal particle interface and few defects. An XRD test is performed on the thin film, and an x-ray diffraction pattern of the heating film is analyzed to be an austenite crystal phase having a face-centered cubic structure. As shown in FIG. 5, an inspection result indicates that the thin film has no obvious crystal particle growth orientation. Measurement is performed by CuKα radiation and θ-2θ scanning, where in an x-ray diffraction pattern exhibited by the iron-based alloy thin film, the ratio of an x-ray diffraction peak intensity of a crystal (111) plane to an x-ray diffraction peak intensity of a (200) plane is 1.87.

### Example 2

Production of a heating thin film:
Step 1): Form, on a heating substrate, an iron-based alloy thin film by using a method of performing direct current (DC) sputtering on an alloy target by using a magnetron spraying device, where the iron-based alloy thin film includes, based on mass percentage: Fe: 63.5%, Cr: 19%, Ni: 13.5%, and Mo: 3.5%, the alloy includes unavoidable impurity content such as C, Si, and P, and a total impurity mass percentage is less than 1%. The heating substrate has an array hole structure and has a void volume of 20%.
Step 2): Perform heat treatment on the formed iron-based alloy thin film, to keep the iron-based alloy thin film at 800°C for 30 min at a vacuum level of 3*10⁻³ Pa, and subsequently, perform cooling with the furnace. The heating substrate covered by the heating thin film is obtained.

A layer of 100 nm of Al₂O₃ protective film is deposited on the surface of the heating thin film, and then the protective film is assembled into a heating component, the effective heating area of the heating thin film being 3.5 mm² (the void ratio is not considered for the value). Further assembly is performed to form the e-cigarette. Dry burning and wet burning tests are performed on the assembled e-cigarette, and test results are as follows:
The dry burning capability of the heating body: a change in the resistance at 8.5 W after dry burning by 10 puffs is 18% (powering on at a constant power of 8.5 W for 3s, and stopping for dry burning in air for 8s); the wet burning capability: a change in the resistance of the strawberry-watermelon-ice-fruit e-liquid at 7.5 W after wet burning by 800 puffs is 10% (vaping at 7.5 W for 3s and stopping for 15s, the capacity being 55 mL).

The cross-sectional topography of the heating film is shown in FIG. 2: the thickness of the thin film is 1700 nm. The thin film is dense, is a block-like equiaxed crystal, and has no obvious crystal particle interface and few defects. An XRD test is performed on the thin film. As shown in FIG. 5, an x-ray diffraction pattern of the heating film is analyzed to be an austenite crystal phase having a face-centered cubic structure, and does not have an obvious crystal growth orientation. Measurement is performed by CuKα radiation and θ-2θ scanning, where in an x-ray diffraction pattern exhibited by the iron-based alloy thin film, the ratio of an x-ray diffraction peak intensity of a crystal (111) plane to an x-ray diffraction peak intensity of a (200) plane is 2.63.

### Example 3

In the heating thin film formed according to the method in Example 1, the iron-based alloy thin film includes, based on mass percentage: Fe: 61%, Cr: 19.5%, Ni: 15%, and Mo: 4%, with the rest being unavoidable impurity content such as C, Si, and P, and a total impurity mass percentage is less than 1%. The other steps are the same as those in Example 1. Dry burning and wet burning tests are performed and a test result is as follows: The dry burning capability of the heating body: a change in the resistance at 8.5 W after dry burning by 10 puffs is 19% (powering on at a constant power of 8.5 W for 3s, and stopping for dry burning in air for 8s); the wet burning capability: a change in the resistance of the strawberry-watermelon-ice-fruit e-liquid at 7.5 W after wet burning by 800 puffs is 9% (vaping at 7.5 W for 3s and stopping for 15s, the capacity being 55 mL).

### Example 4

In the heating thin film formed according to the method in Example 1, the iron-based alloy thin film includes, based on mass percentage: Fe: 71%, Cr: 16.5%, Ni: 10%, and Mo: 2%, with the rest being unavoidable impurity content such as C, Si, and P, and a total impurity mass percentage is less than 1%. The other steps are the same as those in Example 1. Dry burning and wet burning tests are performed and a test result is as follows: The dry burning capability of the heating body: a change in the resistance at 8.5 W after dry burning by 10 puffs is 9% (powering on at a constant power of 8.5 W for 3s, and stopping for dry burning in air for 8s); the wet burning capability: a change in the resistance of the strawberry-watermelon-ice-fruit e-liquid at 7.5 W after wet burning by 800 puffs is 19% (vaping at 7.5 W for 3s and stopping for 15s, the capacity being 55 mL).

### Control Example 1

Production of a heating thin film:
Form, on a heating substrate, an iron-based alloy thin film by using a method of performing direct current (DC) sputtering on an alloy target by using a magnetron spraying device, where the iron-based alloy thin film includes, based on mass percentage: Fe: 70%, Cr: 16.5%, Ni: 10.5%, and Mo: 2.5%, the alloy includes unavoidable impurity content such as C, Si, and P, and a total impurity mass percentage is less than 1%. The heating substrate has an array hole structure and has a void volume of 20%.

A layer of 100 nm of Al₂O₃ protective film is deposited on the surface of the heating thin film, and then the protective film is assembled into a heating component, the effective heating area of the heating thin film being 3.5 mm² (the void ratio is not considered for the value). Further assembly is performed to form the e-cigarette. Dry burning and wet burning tests are performed on the assembled e-cigarette, and test results are as follows:
The dry burning capability of the heating thin film: a change in the resistance at 7.5 W after dry burning by 10 puffs is 90%, and is 19% at 6.5 W after dry burning by 10 puffs (powering on at a constant power of 7.5 W/6.5 W for 3s, and stopping for dry burning in air for 8s); the wet burning capability: a change in the resistance of the strawberry-watermelon-ice-fruit e-liquid at 7.5 W after wet burning by 600 puffs is 15%, and is 35% by 800 puffs (vaping at 7.5 W for 3s and stopping for 15s, the capacity being 55 mL).

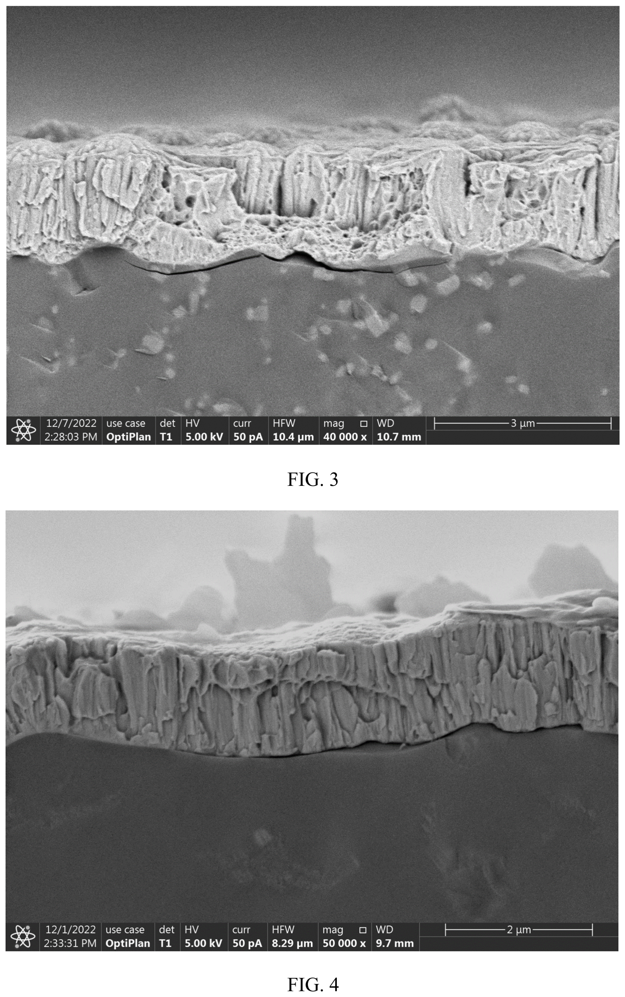

The cross-sectional topography of the heating thin film is shown in FIG. 3: the thickness of the thin film is 1700 nm. The thin film is dense, has obvious prismatic crystal features in some regions, and has obvious crystal interfaces. An XRD test is performed on the thin film. As shown in FIG. 5, an x-ray diffraction pattern of the heating film is analyzed to include an austenite crystal phase having a face-centered cubic structure and a ferrite crystal form of a body-centered cubic structure, and measurement is performed by CuKα radiation and θ-2θ scanning. In an exhibited x-ray diffraction pattern of the iron-based alloy thin film, the peak intensity ratio of a (111) plane in the austenite crystal phase of the face-centered cubic structure to a (200) plane is 4.

### Control Example 2

Production of a heating thin film:
Form, on a heating substrate, an iron-based alloy thin film by using a method of performing direct current (DC) sputtering on an alloy target by using a magnetron spraying device, where the iron-based alloy thin film includes, based on mass percentage: Fe: 63.5%, Cr: 19%, Ni: 13.5%, and Mo: 3.5%, the alloy includes unavoidable impurity content such as C, Si, and P, and a total impurity mass percentage is less than 1%. The heating substrate has an array hole structure and has a void volume of 20%.

A layer of 100 nm of Al₂O₃ protective film is deposited on the surface of the heating thin film, and then the protective film is assembled into a heating component, the effective heating area of the heating thin film being 3.5 mm² (the void ratio is not considered for the value). Further assembly is performed to form the e-cigarette. Dry burning and wet burning tests are performed on the assembled e-cigarette, and test results are as follows:
The dry burning capability of the heating thin film: a change in the resistance at 6.5 W after dry burning by 10 puffs is 83%, and is 18% at 5.5 W after dry burning by 10 puffs (powering on at a constant power of 6.5 W/5.5 W for 3s, and stopping for dry burning in air for 8s); the wet burning capability: a change in the resistance of the strawberry-watermelon-ice-fruit e-liquid at 7.5 W after wet burning by 300 puffs is 17%, and is 38% by 400 puffs (vaping at 7.5 W for 3s and stopping for 15s, the capacity being 55 mL).

The cross-sectional topography of the heating thin film is shown in FIG. 4: the thickness of the thin film is 1750 nm. The cross-sectional topography of the heating film has obvious prismatic crystal features, and a prismatic crystal boundary extends through the height direction of the film layer. As shown in FIG. 5, an x-ray diffraction pattern of the heating film is analyzed to have a ferrite crystal form of a body-centered cubic structure, and grows along the (110) crystal direction.

### Control Example 3

A heating thin film is formed according to the method in Example 1, where the material compositions are the same as those in Example 1, with the difference lies in that the heat treatment temperature of 500°C is selected, the temperature is kept for 60 min, and the other steps are the same as those in Example 1. After detection, a prismatic crystal feature still exists in a cross-section of the prismatic crystal, and a crystal boundary of the prismatic crystal extends through the height direction of the film layer. Dry burning and wet burning tests are performed and a test result is as follows: The dry burning capability of the heating body: a change in the resistance at 7.5 W after dry burning by 10 puffs is 33% (powering on at a constant power of 7.5 W for 3s, and stopping for dry burning in air for 8s); the wet burning capability: a change in the resistance of the strawberry-watermelon-ice-fruit e-liquid at 7.5 W after wet burning by 800 puffs is 23% (vaping at 7.5 W for 3s and stopping for 15s, the capacity being 55 mL).

Obviously, the above examples were merely illustrations for clear description and not limitations on the examples. For those of ordinary skill in the art, other different forms of changes or variations could be made on the basis of the above description. All examples need not and cannot be exhaustive herein. However, the obvious changes or variations derived therefrom still fall within the scope of protection of this application.

## Claims

1. A heating thin film, the heating thin film being an iron-based alloy thin film, and the iron-based alloy thin film having an equiaxed crystal structure.

2. The heating thin film according to claim 1, wherein the heating thin film has a thickness of 0.5-3 µm.

3. The heating thin film according to claim 1, wherein the iron-based alloy thin film is a stainless steel thin film.

4. The heating thin film according to claim 1, wherein the iron-based alloy thin film comprises the following components based on mass percentage:
Fe: 61-72%, Cr: 16-20%, Ni: 10-15%, and Mo: 2-4%.

5. The heating thin film according to claim 4, wherein the iron-based alloy thin film comprises the following components based on mass percentage:
Fe: 67-72%, Cr: 16-18%, Ni: 10-12%, and Mo: 2-3%.

6. The heating thin film according to claim 4, wherein the iron-based alloy thin film comprises the following components based on mass percentage:
Fe: 61-67%, Cr: 18-20%, Ni: 12-15%, and Mo: 3-4%.

7. The heating thin film according to claim 1, wherein the iron-based alloy thin film has an austenite crystal phase having a face-centered cubic structure; and
the iron-based alloy thin film is measured by CuKα radiation and θ-2θ scanning, wherein in an x-ray diffraction pattern exhibited by the iron-based alloy thin film, the ratio of an x-ray diffraction peak intensity of a crystal (111) plane to an x-ray diffraction peak intensity of a (200) plane is (1-3.5) : 1.

8. The heating thin film according to claim 7, wherein the iron-based alloy thin film has no crystal boundaries along the thickness direction.

9. The method for forming a heating thin film according to any one of claims 1 to 8, comprising the following steps:
step 1): forming an iron-based alloy thin film by physical vapor deposition; and
step 2): performing heat treatment on the iron-based alloy thin film in step 1), for the iron-based alloy thin film to form an equiaxed crystal structure, thereby obtaining the heating thin film.

10. The method for forming a heating thin film according to claim 9, wherein in step 1), the iron-based alloy thin film is formed by co-puttering an elemental metal target by physical vapor deposition or puttering an alloy target by physical vapor deposition.

11. The method for producing a heating thin film according to claim 9, wherein a method for the heat treatment in step 2) is: keeping the temperature in a range of 600-800°C for 30-120 min at a vacuum level lower than 5*10⁻² Pa, and performing cooling after the temperature keeping is ended.

12. An atomization core, the atomization core comprising the heating thin film according to any one of claims 1 to 8.

13. The atomization core according to claim 12, wherein the atomization core comprises a heating substrate, the heating thin film is provided on the heating substrate, and a protective film is provided on the heating thin film.

14. An atomization apparatus, the atomization apparatus comprising the heating thin film according to any one of claims 1 to 8 and/or the atomization core according to claim 12 or 13.
